# FASCICULE DE BREVET EUROPEEN

(11) **EP 2 323 077 B1**
(45) Date de publication et mention de la délivrance du brevet: **23.05.2012**
(21) Numéro de dépôt: 10188892.3
(22) Date de dépôt: 26.10.2010
(51) Int. Cl.: G06K 19/077, H01L 23/552, H01L 23/66

(54) **Dispositif électronique comprenant un composant semi-conducteur intégrant une antenne**
Elektronische Vorrichtung, die eine Halbleiterkomponente mit integrierter Antenne enthält
Electronic device including a semi-conductor component integrating an antenna.

(30) Priorité: 10.11.2009 FR 0957941
(43) Date de publication de la demande: 18.05.2011
(73) Titulaire: STmicroelectronics SA, 92120 Montrouge (FR)
(72) Inventeur: Pilard, Romain, 38570 Goncelin (FR); Gloria, Daniel, 73110 Detrier (FR); Gianesello, Frédéric, 73250 Saint-Pierre d'Albigny (FR); Durand, Cédric, 38400 Saint Martin d'Hères (FR)
(74) Mandataire: Zapalowicz, Francis

(56) Documents cités:
- EP-A1- 1 939 979
- EP-A2- 0 874 415
- WO-A1-2008/111914
- US-A1- 2003 042 993

## Description

La présente invention concerne le domaine des composants semi-conducteurs et des dispositifs électroniques comprenant de tels composants.

II existe un besoin d'intégration d'antennes électromagnétiques dans des composants semi-conducteurs et, en même temps, d'amélioration des conditions d'émission/réception des signaux radiofréquence, sans pour autant accroître les espaces occupés dans de tels composants.

Le document EP 1 939 979 décrit un dispositif électronique qui comprend un composant semi-conducteur comprenant un substrat de base en forme de plaquette et, sur un côté de ce substrat, des circuits intégrés comprenant un circuit RF et une antenne reliée à ce circuit RF en vue d'émettre/recevoir des signaux radiofréquence et, sur l'autre côté de ce substrat et en vis-à-vis de l'antenne, une couche métallique.

Selon un aspect de l'invention, il est proposé un dispositif électronique qui comprend en outre au moins un via métallique ménagé dans un trou traversant du substrat, ce via étant relié d'une part à ladite couche métallique et d'autre part au circuit RF, au même potentiel de référence que ladite antenne.

Ladite couche métallique peut s'étendre sur une zone incluant au moins une partie principale de ladite antenne.

Un dispositif électronique peut comprendre une pluralité de vias métalliques ménagés dans des trous traversants du substrat de base et disposés autour d'une zone incluant au moins la partie principale de ladite antenne, ces vias étant reliés d'une part à ladite couche métallique et d'autre part au circuit RF, au même potentiel de référence que ladite antenne.

Ladite couche métallique peut être formée sur la face du substrat de base située dudit autre côté de ce substrat de base.

Ladite couche métallique peut être formée sur une face d'un autre composant, située du côté dudit autre côté du substrat, et comprenant des moyens de connexion électrique interposés entre ledit au moins un via du substrat de base et la couche métallique dudit autre composant.

Des dispositifs électroniques vont maintenant être décrits à titre d'exemples non limitatifs, illustrés par le dessin sur lequel :
- la figure 1 représente une vue de dessus schématique d'un dispositif électronique ;
- la figure 2 représente une coupe transversale approximativement selon II-II du dispositif électronique de la figure 1 ;
- la figure 3 représente une vue de dessus schématique d'un autre dispositif électronique ; et
- la figure 4 représente une coupe transversale approximativement selon IV-IV du dispositif électronique de la figure 3.

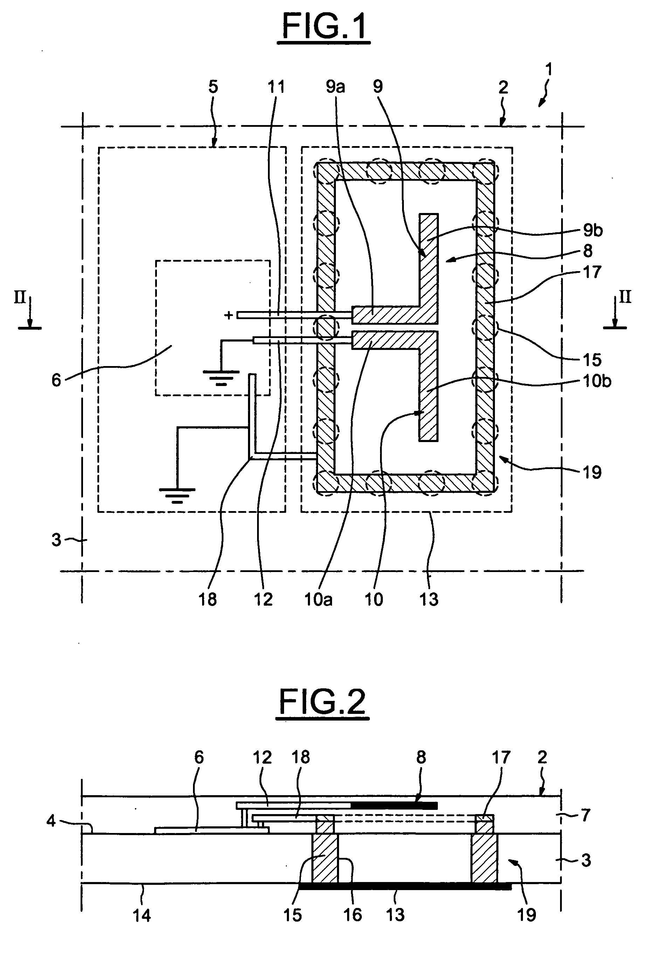

En référence aux figures 1 et 2, on voit qu'un dispositif électronique 1 peut comprendre un composant semi-conducteur 2.

Ce composant semi-conducteur 2 comprend un substrat de base 3 en forme de plaquette, généralement en silicium, sur un côté avant 4 duquel sont réalisés des circuits intégrés 5 comprenant notamment un circuit RF 6 et une couche 7 d'interconnexion. Cette couche 7 comprend généralement différents niveaux métalliques séparés par des sous-couches d'isolants ; des vias de connexion électrique, traversant ces sous-couches, permettant la connexion des différentes pistes métalliques.

Le composant semi-conducteur 2 comprend en outre une antenne métallique 8 aménagée et intégrée dans la couche d'interconnexion 7, sur une zone exempte de circuits intégrés et dans un niveau métallique supérieur.

Dans cet exemple, l'antenne métallique 8 comprend deux parties 9 et 10 qui présentent deux brins 9a et 10a parallèles et proches l'un de l'autre et deux brins 9b et 10b alignés, s'étendant à l'opposé à partir de premières extrémités correspondantes des brins 9a et 10a.

Les autres extrémités des brins 9a et 10a sont reliées au circuit RF 6 par l'intermédiaire de pistes de connexion électriques 11 et 12 et éventuellement de vias adaptés de connexion électrique, intégrés dans la couche 7 d'interconnexion.

Dans une variante de réalisation, en étant excitée par le circuit RF 6 intégré, agissant à titre d'émetteur, l'antenne métallique 8 est apte à émettre des signaux radiofréquence sous forme d'ondes électromagnétiques.

Dans une autre variante de réalisation, le circuit RF 6 agissant à titre de récepteur, l'antenne métallique 8 est apte à capter des ondes électromagnétiques et délivrer des signaux radiofréquence au circuit RF 6 intégré.

Le composant semi-conducteur 2 comprend en outre une couche métallique 13 formée sur un autre côté ou côté arrière 14 du substrat de base 3, opposé à son côté avant 4.

Cette couche métallique 13 s'étend en vis-à-vis de l'antenne métallique 8, sur une zone incluant au moins une partie principale de cette antenne, en particulier toute cette antenne.

Par exemple, la couche métallique 13 peut être de forme rectangulaire et présenter des côtés respectivement parallèles aux brins 9a et 10a et aux brins 9b et 10b et à distance de ces derniers.

Le composant semi-conducteur 2 comprend en outre une pluralité de vias métalliques 15 ménagés ou réalisés dans des trous 16 traversant dans le sens de son épaisseur le substrat de base 3.

Les vias métalliques 15 peuvent être disposés à la périphérie de la couche métallique 13, de telle sorte que la partie périphérique de cette couche métallique 13 recouvre leurs extrémités situées sur le côté 14 du substrat de base 3, en réalisant ainsi une connexion électrique.

Par exemple, les vias métalliques 15 peuvent être placés à λ/4 des branches 9b et 10b de l'antenne 8 et régulièrement répartis le long de la périphérie de la couche métallique 13, la distance entre eux pouvant être approximativement égale à λ/10, λ étant la longueur d'onde de travail de l'antenne.

Le composant semi-conducteur 2 comprend en outre, intégrée dans un niveau métallique inférieur de la couche 7 d'interconnexion, une piste avant rectangulaire d'interconnexion 17 passant au-dessus des extrémités des vias métalliques 15 situées sur le côté 4 du substrat de base 3 et reliée au circuit RF 6 intégré par une piste métallique 18 également intégrée dans la couche 7 d'interconnexion.

Le circuit RF 6 peut être apte à générer un potentiel de référence commun à l'antenne métallique 8 et à l'ensemble 19 formé par la couche métallique 13, les vias métalliques 15 et la piste métallique 18, électriquement reliés par la piste avant d'interconnexion 17, cet ensemble 19 formant une cavité intégrée de part et d'autre et au travers du substrat de base 3.

Dans la zone ou le volume délimités par cet ensemble 19, le composant semi-conducteur 2 peut ne présenter aucune autre partie métallique que l'antenne métallique 8 et éventuellement en partie les moyens de connexion de cette dernière au circuit RF 6.

La couche métallique 13 forme un organe apte à empêcher les ondes électromagnétiques générées par l'antenne métallique 8, émettrice, de s'échapper vers l'extérieur au travers et par l'arrière du substrat de base 3 et à réfléchir ces ondes électromagnétiques, de telle sorte que le rayonnement électromagnétique de l'antenne métallique 8 se produit vers l'extérieur par l'avant du substrat de base 3 sur lequel elle est formée.

Les vias métalliques 15 aménagés au travers du substrat de base 3, éventuellement complétés par la piste d'interconnexion 17, contribuent aux effets ci-dessus et en outre isolent les circuits intégrés 5 des rayonnements électromagnétiques de l'antenne métallique 8 et l'antenne métallique 8 des rayonnements électromagnétiques des circuits intégrés 5.

L'antenne métallique 8, réceptrice, se trouve confinée dans le volume de l'ensemble 19 pour être sensible aux ondes électromagnétiques apparaissant du côté avant du composant semi-conducteur 2, sans être perturbée par des rayonnements électromagnétiques provenant de l'extérieur, par l'arrière, ou provenant des circuits intégrés 5.

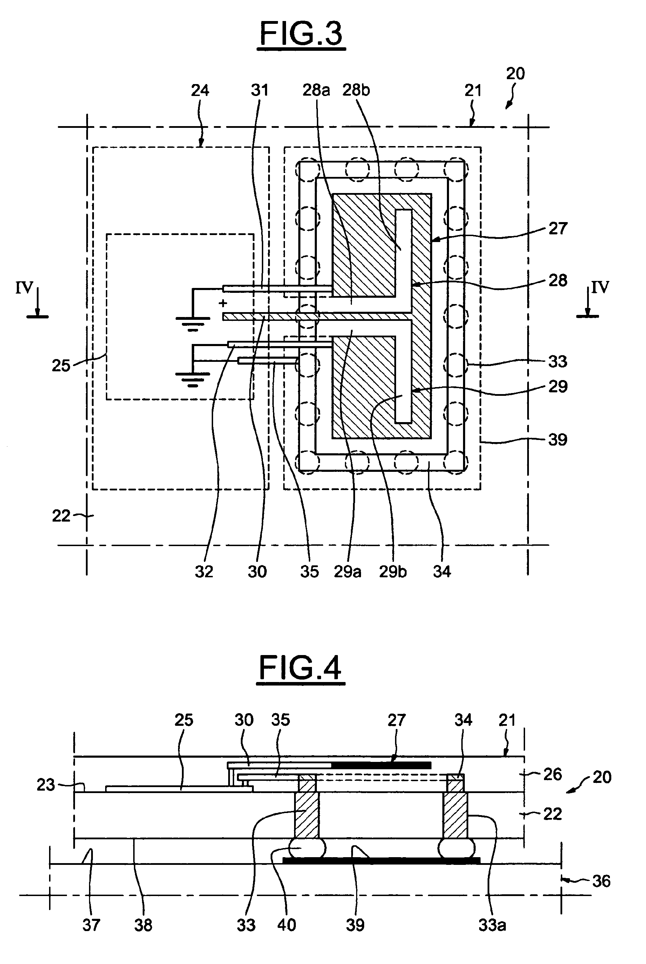

En référence aux figures 3 et 4, on voit qu'un autre dispositif électronique 20 peut comprendre un composant semi-conducteur 21.

Comme dans l'exemple précédent, ce composant semi-conducteur 21 comprend un substrat de base 22 en forme de plaquette, généralement en silicium, sur un côté avant 23 duquel sont réalisés des circuits intégrés 24 comprenant notamment un circuit RF 25 et une couche d'interconnexion 26 sur ce côté 23.

Le composant semi-conducteur 21 comprend en outre une antenne métallique 27 intégrée dans un niveau supérieur de la couche d'interconnexion 26, sur une zone exempte de circuits intégrés.

Dans cet exemple, l'antenne métallique 26 comprend une couche métallique rectangulaire 27 qui présente deux découpes d'évidements en forme de L 28 et 29 ayant deux branches parallèles 28a et 29a, proches l'une de l'autre, et deux branches 28b et 29b s'étendant à l'opposé l'une de l'autre, les branches parallèles 28a et 29a débouchant sur un côté long de la couche métallique rectangulaire 27.

Les branches parallèles 28a et 29a ménagent entre elles une piste de connexion électrique 30 de la couche métallique rectangulaire 27, se prolongeant pour être reliée au circuit RF 25.

De part et d'autre des parallèles 28a et 29a, des pistes de connexion électrique 31 et 32 de la couche d'interconnexion 26 relient la couche métallique rectangulaire 27 à un potentiel de référence du circuit RF 25.

L'antenne métallique 27 peut fonctionner comme l'antenne métallique 8 de l'exemple précédent.

Le composant semi-conducteur 21 comprend en outre une pluralité de vias métalliques 33 ménagés ou réalisés dans des trous 33a traversant dans le sens de son épaisseur le substrat de base 3.

Ces vias métalliques 33 sont disposés à l'extérieur et à distance de la zone rectangulaire couverte par l'antenne 27.

Le composant semi-conducteur 21 comprend en outre, intégrée dans un niveau métallique inférieur de la couche 26 d'interconnexion, une piste rectangulaire d'interconnexion 34 passant au-dessus des extrémités des vias métalliques 33 situées sur le côté 23 du substrat de base 22 et reliée au circuit RF 25 intégré par une piste métallique 35 également intégrée dans la couche 22 d'interconnexion.

Cette piste métallique 34 peut être reliée au potentiel de référence du circuit RF 25, de telle sorte que les vias 33 sont reliés à ce potentiel de référence.

Le dispositif électronique 20 peut comprendre en outre un autre composant 36 présentant une face 37 adjacente et distante du côté arrière 38 du substrat 22 opposé à son côté avant 23.

Cet autre composant 36, qui peut être un autre composant semi-conducteur ou une plaque de circuit imprimé, porte sur sa face 37 une couche métallique rectangulaire 39 dont la périphérie enveloppe les vias métalliques 33.

Entre la partie périphérique de la couche métallique 39 et les extrémités des vias métalliques 33 situées du côté 38 du substrat de base 22 sont interposées des billes de connexion électrique 40, de telle sorte que la couche métallique 39 se trouve ainsi reliée au potentiel de référence du circuit RF 25.

La couche métallique 39 et les vias métalliques 33, ainsi qu'éventuellement la piste rectangulaire d'interconnexion 34 et les billes de connexion électrique 40 peuvent générer les effets de réflexion, de protection et de confinement correspondant à ceux de la couche métallique 13 des vias métalliques 15 et de la piste d'interconnexion 17 de l'exemple décrit en référence aux figures 1 et 2.

La présente invention ne se limite pas aux exemples ci-dessus décrits. Bien d'autres exemples sont possibles notamment en ce qui concerne la forme des antennes et la forme des moyens de réflexion des ondes électromagnétiques et de protection électromagnétique.

## Revendications

1. Dispositif électronique comprenant un composant semi-conducteur (2, 21) comprenant un substrat de base (3, 22) en forme de plaquette et, sur un côté de ce substrat, des circuits intégrés comprenant un circuit RF (6, 25) et une antenne (8, 27) reliée à ce circuit RF en vue d'émettre/recevoir des signaux radiofréquence, et comprenant en outre une couche métallique (13, 39) située d'un autre côté du substrat, en vis-à-vis de ladite antenne, **caractérisé par le fait qu'**il comprend en outre au moins un via métallique (15, 33) ménagé dans un trou traversant du substrat, ce via étant relié d'une part à ladite couche métallique et d'autre part au circuit RF, au même potentiel de référence que ladite antenne.

2. Dispositif selon la revendication 1, dans lequel ladite couche métallique s'étend sur une zone incluant au moins une partie principale de ladite antenne.

3. Dispositif selon l'une des revendications 1 et 2, comprenant une pluralité de vias métalliques (15, 33) ménagés dans des trous traversants (16, 34) du substrat de base et disposés autour d'une zone incluant au moins la partie principale ladite antenne, ces vias étant reliés d'une part à ladite couche métallique et d'autre part au circuit RF, au même potentiel de référence que ladite antenne.

4. Dispositif selon l'une quelconque des revendications précédentes, dans lequel ladite couche métallique (13) est formée sur la face du substrat de base située dudit autre côté de ce substrat de base.

5. Dispositif selon l'une quelconque des revendications 1 à 3, dans lequel ladite couche métallique (39) est formée sur une face d'un autre composant (36), située du côté dudit autre côté du substrat, et comprenant des moyens de connexion électrique interposés entre ledit au moins un via du substrat de base et la couche métallique dudit autre composant.

## Claims

1. Electronic device comprising a semiconductor component (2, 21) comprising a base substrate (3, 22) in the form of a wafer and, on one side of this substrate, integrated circuits comprising an RF circuit (6, 25) and an antenna (8, 27) connected to this RF circuit in order to transmit/receive radiofrequency signals, and further including a metal layer (13, 39) located on the other side of the substrate from said antenna, **characterized in that** it further comprises at least one metal via (15, 33) provided in a through-hole in the substrate, this via being connected on one side to said metal layer and on the other side to the RF circuit, at the same reference potential as said antenna.

2. Device according to Claim 1, in which said metal layer extends over an area that includes at least a main portion of said antenna.

3. Device according to either of Claims 1 and 2, comprising a plurality of metal vias (15, 33) provided in through-holes (16, 34) in the base substrate and placed around an area including at least the main portion of said antenna, these vias being connected on one side to said metal layer and on the other side to the RF circuit, at the same reference potential as said antenna.

4. Device according to any one of the preceding claims, in which said metal layer (13) is formed on that face of the base substrate which is located on said other side of this base substrate.

5. Device according to any one of Claims 1 to 3, in which said metal layer (39) is formed on a face of another component (36) and located on the side of said other side of the substrate, and comprising electrical connection means interposed between said at least one via of the base substrate and the metal layer of said other component.

## Patentansprüche

1. Elektronische Vorrichtung, die ein Halbleiterbauteil (2, 21) enthalt, das ein Basissubstrat (3, 22) in Form einer Platte und auf einer Seite dieses Substrats eine RF-Schaltung (6, 25) enthaltende integrierte Schaltungen und eine Antenne (8, 27) enthalt, die mit dieser RF-Schaltung verbunden ist, um Hochfrequenzsignale zu senden/zu empfangen, und außerdem eine Metallschicht (13, 39) enthalt, die sich auf einer anderen Seite des Substrats gegenuber der Antenne befindet, **dadurch gekennzeichnet, dass** sie außerdem mindestens eine metallische Lücke (15, 33) enthalt, die in einem Durchgangsloch des Substrats ausgespart ist, wobei diese Lücke einerseits mit der Metallschicht und andererseits mit der RF-Schaltung auf dem gleichen Bezugspotential wie die Antenne verbunden ist.

2. Vorrichtung nach Anspruch 1, bei der die Metallschicht sich uber eine Zone erstreckt, die mindestens einen Hauptbereich der Antenne enthalt.

3. Vorrichtung nach einem der Anspruche 1 und 2, die eine Vielzahl von metallischen Lucken (15, 33) enthalt, die in Durchgangslochern (16, 34) des Basissubstrats ausgespart und um eine Zone herum angeordnet sind, die mindestens den Hauptbereich der Antenne enthält, wobei diese Lucken einerseits mit der Metallschicht und andererseits mit der RF-Schaltung auf dem gleichen Bezugspotential wie die Antenne verbunden sind.

4. Vorrichtung nach einem der vorhergehenden Ansprüche, bei der die Metallschicht (13) auf der Seite des Basissubstrats geformt ist, die sich auf der anderen Seite dieses Basissubstrats befindet.

5. Vorrichtung nach einem der Anspruche 1 bis 3, bei der die Metallschicht (39) auf einer Seite eines anderen Bauteils (36) geformt ist, die sich auf der Seite der anderen Seite des Substrats befindet und elektrische Verbindungseinrichtungen enthält, die zwischen die mindestens eine Lücke des Basissubstrats und die Metallschicht des anderen Bauteils eingefugt sind.
